# EUROPEAN PATENT APPLICATION

(11) **EP 4 517 393 A1**
(43) Date of publication of application: **05.03.2025**
(21) Application number: 24197256.1
(22) Date of filing: 29.08.2024
(51) Int. Cl.: G01V 3/15, G01V 3/165

(54) **SYSTEM AND METHOD FOR MITIGATING SELF-GENERATED INTERFERENCE**

(30) Priority: 01.09.2023 US 202363580047 P
(71) Applicant: Radiodetection Ltd., Bristol BS14 0AF (GB)
(72) Inventor: GOODWIN, Stephen James, Chelworth (GB); PAPADOGEORGOS, Elias, Cardiff (GB); THOMPSON, Jeffrey Richard, Cheltenham (GB); WARD, Richard Frederick George, Bristol (GB)
(74) Representative: Viering, Jentschura & Partner mbB Patent- und Rechtsanwälte

(57) **Abstract**

An underground utility locator is provided. The underground utility locator includes a wand, a GNSS module, a power module, a smoothing circuit, and a multi-layer enclosure. The wand has a top end and a bottom end and includes at least one antenna configured to output a field strength signal in response to an electromagnetic field. The GNSS module is coupled to the top end of the wand. The power module is coupled to the wand. The multi-layer enclosure at least partially surrounds the GNSS module and includes an outer shell layer and an inner shell layer. The outer shell layer and the inner shell layer are partially separated by an air gap.

## Description

### TECHNOLOGY FIELD

This disclosure generally relates to buried asset detection. More specifically, the disclosure relates to a method and apparatus related to an electromagnetic locator device that mitigates self-generated interference.

### BACKGROUND

It is useful to accurately locate buried cables and pipes before commencing digging or any excavation project to ensure that the cables and pipes are avoided. To locate underground assets, an electromagnetic locator device can be used to detect electromagnetic signals conducted by a buried cable, pipeline, etc. For example, the electromagnetic signal may be associated with mains electricity in the case of buried power lines, re-radiated low frequency radio signal transmissions, or induced signals connected directly or indirectly to the buried conductor from a partnering transmitter.

In some applications, the electronic components associated with or disposed at least partially or entirely within the locator device itself may produce signals that interfere with the ability of the locator device to detect the presence of buried cables and pipes with precision. For example, in some applications, directly radiated interference and re-radiated, or conducted interference generated by elements of the locator electronics escape their locality and interfere with the detection of signals measured by other locator electronics. Accordingly, it would be beneficial to provide an improved electromagnetic locator device.

### SUMMARY

Some embodiments include an underground utility locator. The underground utility locator may include a wand, a GNSS module, a power module, and a multi-layer enclosure. The wand may have a top end and a bottom end and may include at least one antenna configured to output a field strength signal in response to an electromagnetic field. The power module may be coupled to the wand. The power module includes a smoothing circuit for providing a substantially constant current. The multi-layer enclosure may at least partially surround the GNSS module. The multi-layer enclosure may include an outer metal shell layer and an inner metal shell layer that may be partially separated by an air gap.

In some forms, the underground utility locator includes an electronics housing and a power module housing. The electronics housing and the multi-layer enclosure may be coupled to the top end of the wand. The GNSS module may be positioned within the electronics housing. The power module may be positioned within the power module housing. In some forms, the outer metal shell layer is provided as a first metal, such as aluminum, and the inner metal shell layer is provided as a second metal, such as steel. The multi-layer enclosure may further include at least one spacer above the inner metal shell layer and at least one spacer below the inner metal shell layer. The multi-layer enclosure may have an inner shell lid mounted to an inner shell bottom and an outer shell lid mounted to the outer shell bottom. The inner shell lid may be mounted to the inner shell bottom, and the outer shell lid may be mounted to the outer shell bottom.

In accordance with another embodiment, an underground utility locator is disclosed. The underground utility locator may include a wand, a GNSS module, a multi-layer enclosure, a power module, and an outgoing current from the power module to the GNSS module. The wand is defined by a top end and a bottom end and includes at least one antenna designed to output a field strength signal in response to an electromagnetic field. The power module may be coupled to the wand. The multi-layer enclosure may at least partially surround the GNSS module.

The locator further includes the power module, which may include a smoothing circuit for providing a substantially constant current. The smoothing circuit may include an incoming rippling current with a rippling effect and a rippling voltage from a power supply, a reservoir capacitor with a rippling voltage, a feedback capacitor, and a feedforward capacitor. The reservoir capacitor discharges to reduce the rippling effect of the incoming rippling current. The feedback capacitor may control the quality-factor (Q) of a filter of the smoothing circuit. The feedforward capacitor can deliver the rippling effect of the incoming rippling current.

In some forms, the underground utility locator includes an electronics housing and a power module housing. The electronics housing and the multi-layer enclosure may be coupled to the top end of the wand. The GNSS module may be positioned within the electronics housing. The power module may be positioned within the power module housing.

In some embodiments, the feedforward capacitor may feed in a proportion of the rippling current into a control circuit with an active switch, which in turn will aim to reduce the incoming rippling current. The rippling voltage on the reservoir capacitor may be permitted to ripple if the rippling voltage is within a permitted range. The feedback capacitor lowers a frequency response of the smoothing circuit. The feedback capacitor may be tuned to be as large as possible without creating low frequency ringing and impacting the impulse response. The reservoir capacitor may control a local supply of current and the smoothing circuit may top up the charge on the reservoir capacitor to maintain the local supply. The reservoir capacitor can control a frequency attenuation, and the feedback capacitor can control a step performance. The GNSS module may demand a variable current.

In accordance with yet another embodiment, a method of mitigating interference from radiated emissions in an underground utility locator is disclosed. The method may include the step of providing a wand with a top end and a bottom end. The wand may include at least one antenna configured to output a field strength signal in response to an electromagnetic field. The method may include the step of providing a system circuit including a GNSS module. The method may further include the step of providing a multi-layer enclosure at least partially surrounding the GNSS module. The multi-layer enclosure may include an outer shell layer and an inner shell layer, whereby the outer shell layer and the inner shell layer may be at least partially separated by an air gap. The method may include the step of providing a power module coupled to the wand. The power module may include a smoothing circuit.

In some forms, the smoothing circuit may include an electric current monitor, an incoming rippling current with a rippling effect, a reservoir capacitor with a rippling voltage, a feedback capacitor, and a feedforward capacitor. The reservoir capacitor may discharge to reduce the rippling effect of the incoming rippling current. The feedback capacitor may control a quality factor of a filter of the smoothing circuit. The feedforward capacitor may deliver the rippling effect of the incoming rippling current. The method may include the step of storing a charge via the reservoir capacitor. The method may include the step of discharging the charge from the reservoir capacitor when the voltage drops below a threshold voltage value. The method may include the step of filtering out frequencies within a specified range from a current drawn by the system circuit. The method may include the step of delivering a substantially constant current to the system circuit. The specified range may be anywhere, but not exclusively, between 45Hz to 250kHz.

### DESCRIPTION OF THE DRAWINGS

FIG. 1 is a front elevational view of a locator device according to an embodiment;
FIG. 2 is a side plan view of the locator device of FIG. 1;
FIG. 3 is a top isometric view of a multi-layer enclosure that is compatible with the locator of FIG. 1, with some parts rendered transparently for clarity;
FIG. 4 is a top isometric view of the multi-layer enclosure of FIG. 3 with some parts rendered transparently for clarity;
FIG. 5 is a top isometric view of the multi-layer enclosure of FIG. 3 with some parts rendered transparently for clarity;
FIG. 6 is a top isometric view of the multi-layer enclosure of FIG. 3 with some parts rendered transparently for clarity;
FIG. 7 is a top isometric view of the multi-layer enclosure of FIG. 3 with some parts rendered transparently for clarity;
FIG. 8 is a top isometric view of the multi-layer enclosure of FIG. 3;
FIG. 9 is a block diagram of a power module and a load without a smoothing circuit fitted;
FIG. 10 is a block diagram of the power module and the load of FIG. 9 fitted with a smoothing circuit and a multi-layer enclosure according to an embodiment;
FIG. 11 is a detailed electrical circuit diagram of the smoothing circuit of FIG. 10 according to an embodiment, the smoothing circuit being connected to a power module and a load;
FIG. 12a is a circuit diagram of a smoothing circuit according to an embodiment, the circuit being simulated in LTspice^{®};
FIG. 12b is a circuit diagram of an RC filter circuit as simulated in LTspice^{®} and designed to simulate an unsmoothed circuit;
FIG. 13 is a detailed electrical circuit schematic diagram of a circuit incorporating the elements of the smoothing circuit of FIG. 12a;
FIG. 14 is an LTspice^{®} frequency response plot of the simulation circuits of FIGS. 12a and 12b;
FIG. 15 is a measured frequency plot of conducted emissions of an RTK GNSS module; and
FIG. 16 is a measured frequency plot of the conducted emissions of the RTK GNSS module with the smoothing circuit and reservoir capacitor of FIG. 12a implemented.

### DETAILED DESCRIPTION

The following discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to the embodiments shown but are to be accorded the widest scope consistent with the principles and features disclosed herein. The figures, which are not necessarily to scale, depict selected embodiments and are not intended to limit the scope of embodiments of the invention. Skilled artisans will recognize that the examples provided herein have many useful alternatives that fall within the scope of embodiments of the invention.

It is to be understood that the phraseology and terminology used herein are for the purpose of description and should not be regarded as limiting. For example, the use of "including," "comprising," or "having" and variations thereof herein is meant to encompass the items listed thereafter and equivalents thereof, as well as additional items. As used herein, unless otherwise specified or limited, the terms "mounted," "connected," "supported," and "coupled" and variations thereof are used broadly and encompass both direct and indirect mountings, connections, supports, and couplings. Further, unless otherwise specified or limited, "connected" and "coupled" are not restricted to physical or mechanical connections or couplings.

As used herein, unless otherwise specified or limited, "at least one of A, B, and C," and similar other phrases, are meant to indicate A, or B, or C, or any combination of A, B, and/or C. As such, this phrase, and similar other phrases can include single or multiple instances of A, B, and/or C, and, in the case that any of A, B, and/or C indicates a category of elements, single or multiple instances of any of the elements of the categories A, B, and/or C.

As mentioned above, it would be useful to provide an improved electromagnetic locator device that reduces self-generated interference. For example, a locator device with improved sensitivity and performance that mitigates or prevents conducted interference and radiated interference generated by elements of the locator electronics would be useful.

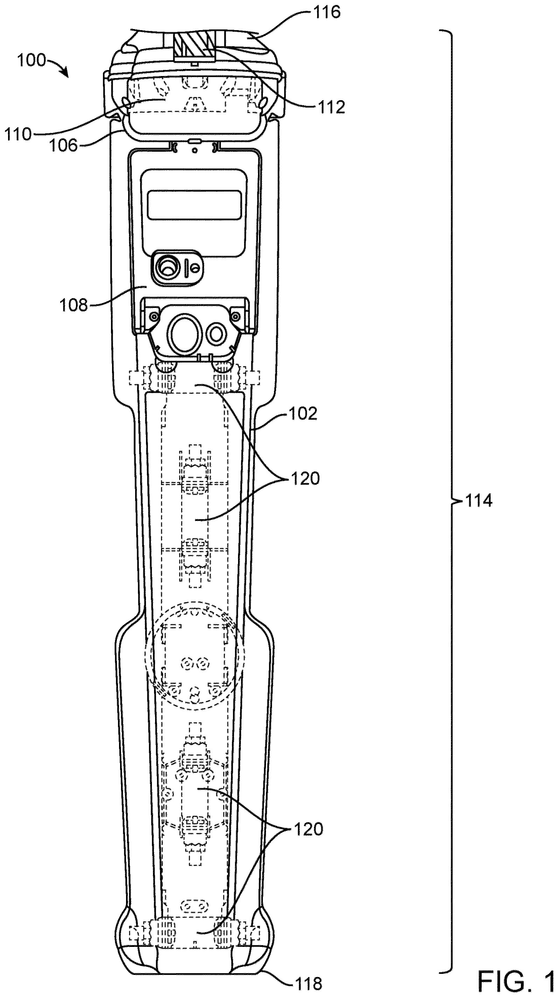

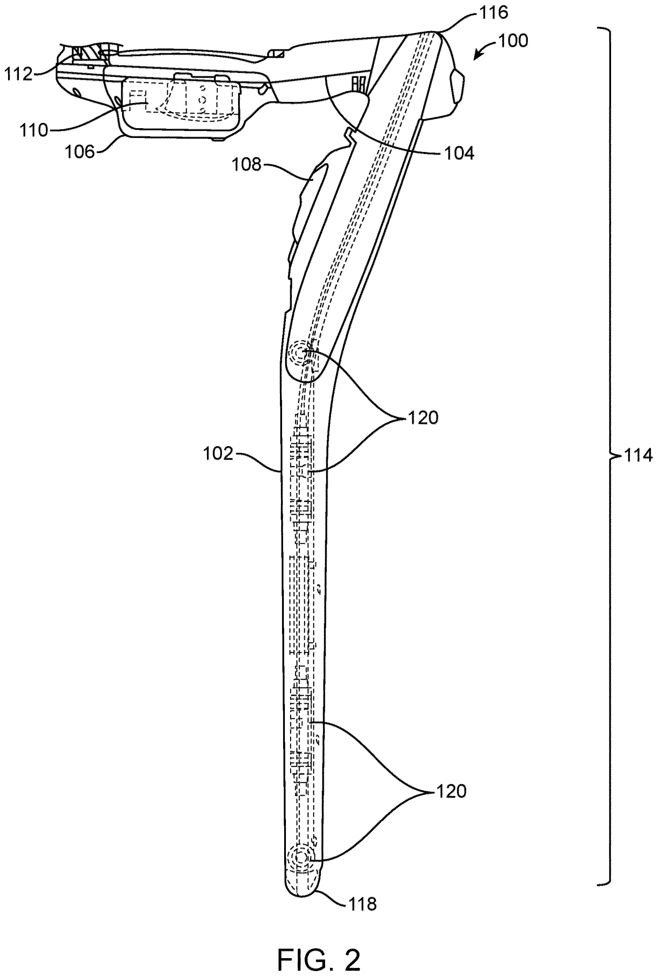

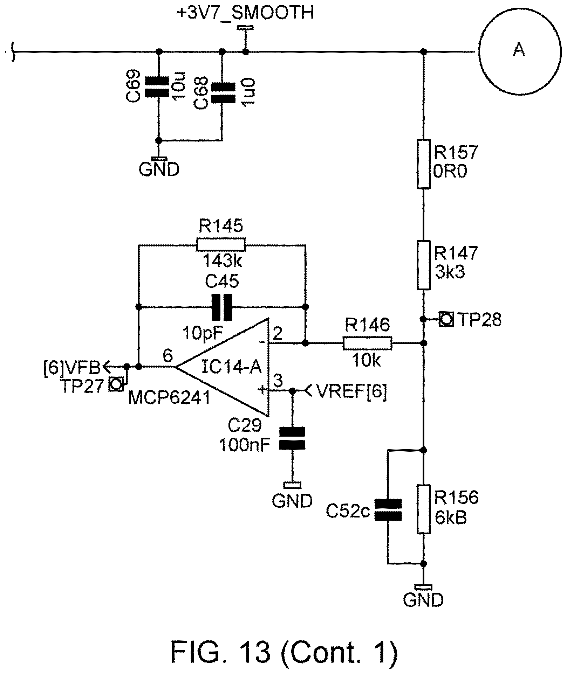

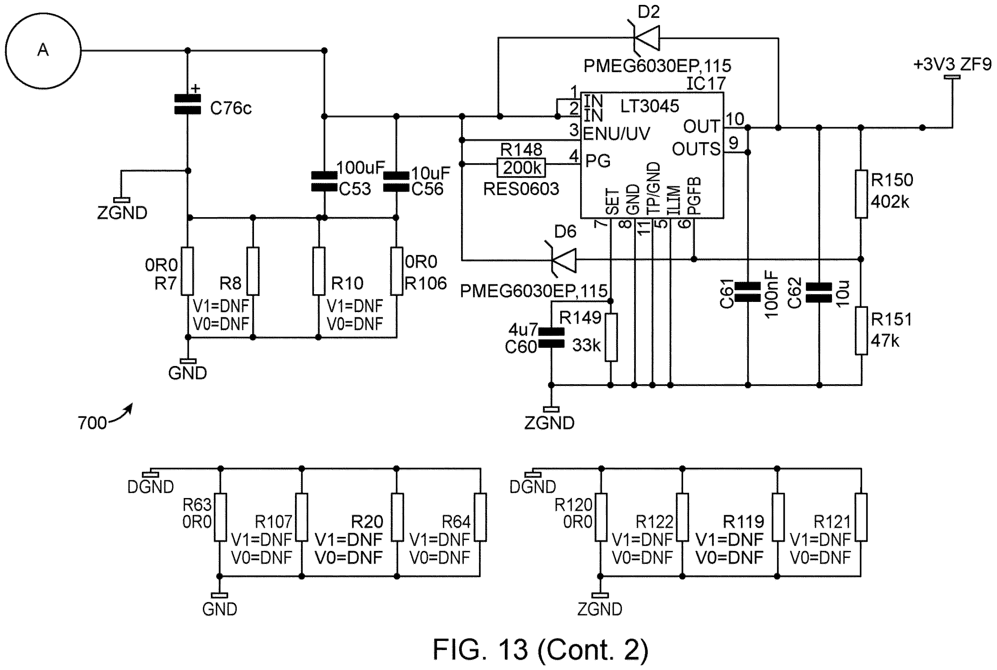

FIGS. 1 and 2 illustrate an underground utility locator device 100 that is designed to detect buried conductors and other underground assets. The underground utility locator device 100 is provided in the form of a wand 102, a handle 104, an electronics housing 106, a power module housing 108, a multi-layer enclosure 110, and a GNSS antenna 112.

The wand 102 is defined by an elongated housing 114 having a top end 116, a bottom end 118, and at least one electromagnetic field antenna 120. The electromagnetic field antennas 120 are configured to generate a field strength signal in response to an electromagnetic field, such as the electromagnetic fields that are generated by underground current-carrying conductors or other underground assets that are connected directly or indirectly to a partnering electromagnetic signal transmitter. As a non-limiting example, the electromagnetic field antennas 120 can be provided in the form of ferrite rod antennas. Accordingly, the electromagnetic field antennas 120 can be used to detect the presence of underground assets. As depicted in FIGS. 1 and 2, four antennas 120 are associated with the housing 114 of the wand 102, although more or fewer antennas 120 may be included depending on the specific application of the locator device 100.

The electronics housing 106 is coupled to the top end 116 of the wand 102. In some forms, the electronics housing 106 is coupled to the wand 102 by way of the handle 104. The GNSS antenna 112 can also be coupled to the electronics housing 106. In some forms, the GNSS antenna 112 is positioned inside of the electronics housing 106. In some other forms, the GNSS antenna 112 is positioned along the handle 104. Additionally, in some other forms, the GNSS antenna 112 is coupled to the top end 116 of the wand 102. To aid in the detection of underground assets, the locator device 100 can also include one or more of a display, a keypad, a speaker, a USB port, an accessory connector, a headphone connector, and/or Bluetooth modules, which can each be provided within the electronics housing 106 and/or can be coupled to the electronics housing 106.

The GNSS module (not shown), the multi-layer enclosure 110, and various system electronics (not shown) are disposed within the electronics housing 106. The GNSS module includes a receiver for receiving satellite geolocation data, such as data transmitted via GPS, GLONASS, Baidu, Galileo, or other satellite constellations. In some forms, the GNSS module is enabled for real-time kinematic positioning (RTK) and, thus, is configured to receive RTK correction data. The GNSS module and/or the system electronics can automatically store satellite geolocation data to provide comprehensive mapping capabilities. Further, the system electronics can be configured to implement and direct the functions of the locator device 100. For example, the system electronics can include a microprocessor and a memory.

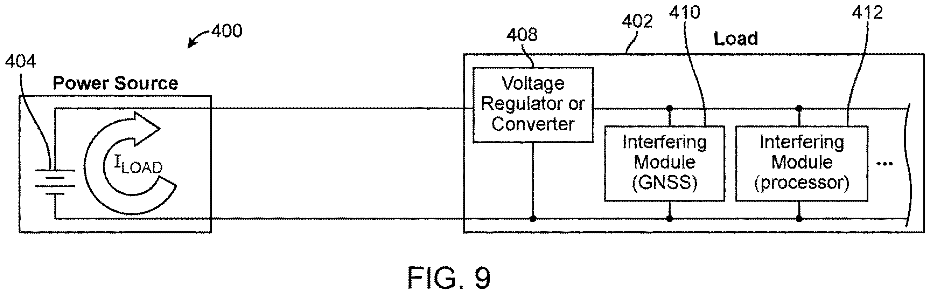

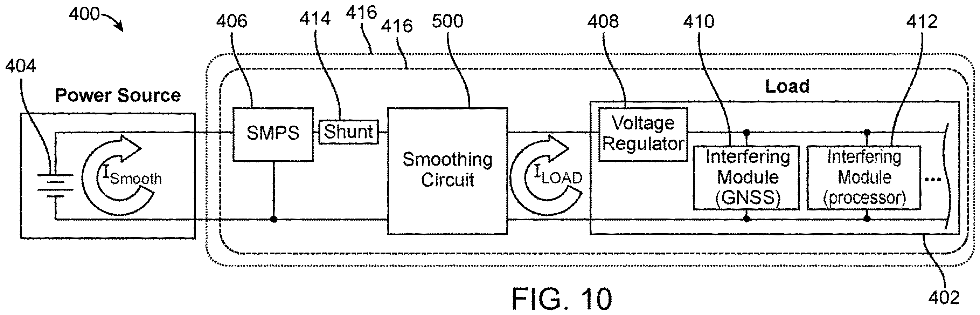

The power module housing 108 is coupled to the wand 102 and contains a power module (not shown) or portions thereof. The power module housing 108 can be coupled to the wand 102 in a variety of locations anywhere between the top end 116 of the wand 102 and the bottom end 118 of the wand 102. In some forms, positioning the power module and power module housing 108 toward the top end 116 of the wand 102 and/or the handle 104 helps to prevent the interference of conducted and re-radiated emissions from the power module, which can affect the accuracy of the electromagnetic field antennas 120. In some forms, the power module includes a power supply and a battery (not shown). The power supply can be provided in the form of a switched-mode power supply (SMPS) with constant voltage output. In some embodiments, the SMPS is housed within the multi-layer enclosure 110. In some embodiments, the battery is housed within the power module housing 108. In some embodiments, the battery is retained in a separate battery compartment. The battery can be provided in the form of a Lithium-Ion battery (Li-Ion), a D-cell alkaline battery, or a D-cell NiMH battery, to name a few non-limiting examples. Here, the power module can also be electrically coupled to a smoothing circuit. Example smoothing circuits 500, 600 are described further below with respect to FIGS. 9 and 10.

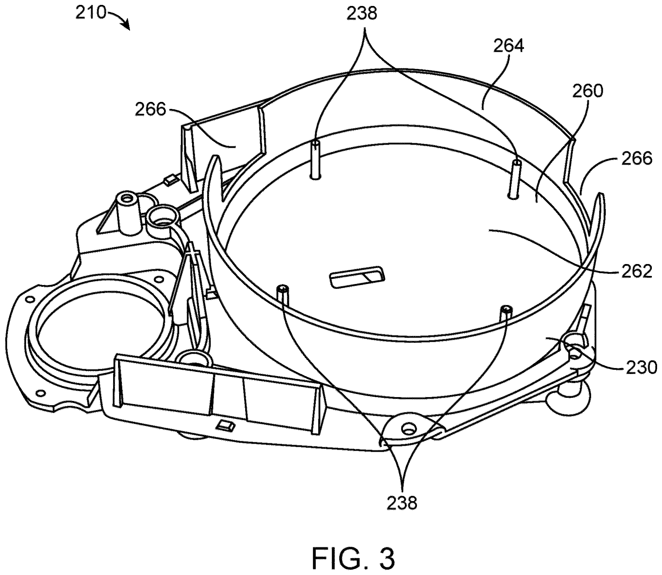

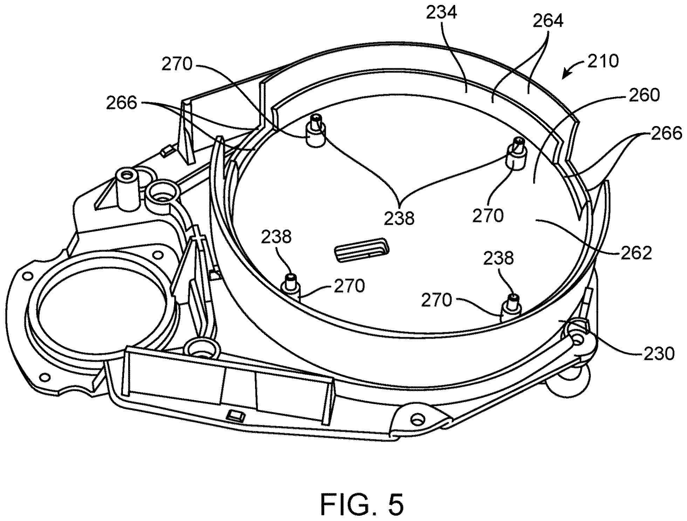

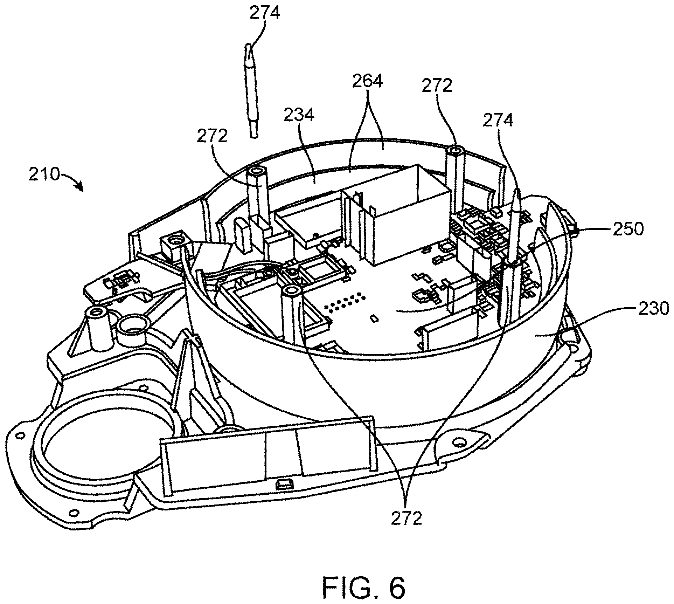

FIGS. 3-8 illustrate an embodiment of a multi-layer enclosure 210 that is compatible with the locator device 100 of FIGS. 1 and 2, for example, in place of the multi-layer enclosure 110. The multi-layer enclosure 210 may be provided in the form of an outer shell bottom 230, an outer shell lid 232, an inner shell bottom 234, an inner shell lid 236, a plurality of guide pin posts 238, fasteners 240, and one or more spacers 242a, 242b having a thickness dimension. The multi-layer enclosure 210 is configured to at least partially surround, or entirely enclose, a GNSS receiver module 250 (see FIG. 6), such as the GNSS module described above with respect to FIGS. 1 and 2.

Each of the outer shell bottom 230, the outer shell lid 232, the inner shell bottom 234, and the inner shell lid 236 can be provided in the form of a body 260 defined by a flat surface 262 with a sidewall 264 extending upwardly therefrom. The sidewall 264 of each of the inner shell bottom 234 and the outer shell bottom 234 further includes a plurality of rectilinear cutouts 266 circumscribing the sidewall 264. In the embodiment depicted, two rectilinear cutouts 266 are provided and extend entirely through the sidewall 264 of the inner shell bottom 234 and the outer shell bottom 234.

Each of the outer shell bottom 230, the outer shell lid 232, the inner shell bottom 234, and the inner shell lid 236 are provided in the form of a hollow, substantially half-cylindrical housing, but other forms are also contemplated, such as a substantially rectangular cuboid or an irregular polyhedron. The outer shell lid 232 and outer shell bottom 230 can be sized and shaped to provide corresponding halves of a cylinder, and the inner shell lid 236 and inner shell bottom 234 can also be sized and shaped to provide corresponding halves of a cylinder. In some forms, when coupled together, the sidewall 264 of one of the outer shell lid 232 or the outer shell bottom 230 can at least partially overlap the sidewall 264 of the other to form a nested outer shell layer that defines an outer layer hollow internal volume. Similarly, when coupled together, the sidewall 264 of one of the inner shell lid 236 or the inner shell bottom 234 can at least partially overlap the sidewall 264 of the other to form a nested inner shell layer that defines an inner layer hollow internal volume.

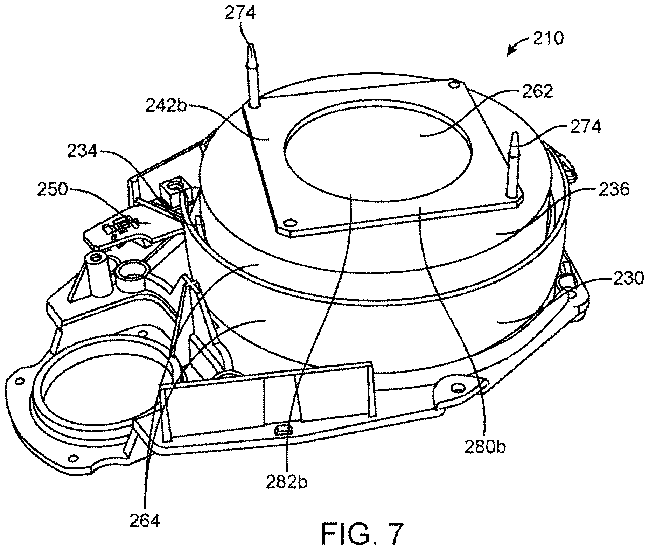

As shown in FIG. 7, the inner shell bottom 234 and the inner shell lid 236 can be sized and shaped such that when coupled together, the inner shell bottom 234 and the inner shell lid 236 can be nested within the outer layer hollow internal volume formed by the outer shell lid 232 and the outer shell bottom 230. Accordingly, when the inner shell lid 236 and the inner shell bottom 234 are coupled together inside of the outer shell lid 232 and the outer shell bottom 230, the outer shell lid 232 and the outer shell bottom 230 being coupled together, the inner shell layer and the outer shell layer provide multiple, distinct layers of the multi-layer enclosure 210. The inner layer internal volume can be sized and shaped to receive, surround, or substantially enclose at least a portion of or the entire GNSS receiver module 250. Thus, when the multi-layer enclosure 210 is assembled, both the inner shell layer and the outer shell layer at least partially or entirely surround the GNSS receiver module 250.

To assist with fitting the inner shell bottom 234 onto the outer shell bottom 230, respectively, both the inner shell bottom 234 and outer shell bottom 230 may contain four equally spaced holes that may be about 2mm to 3mm in diameter, such as 2.8mm. Additionally, the outer shell bottom 230 contains a plurality of guide pin posts 238. In some instances, there are four guide pin posts 238 that extend upwardly from the surface 262 of the outer shell bottom 230. Additionally, the inner shell bottom 234 contains a plurality of hollow columns 270 protruding upwardly from the flat surface 262, which are configured to receive the guide pin posts 238. When the inner shell bottom 234 is placed into the outer shell bottom 230, the guide pin posts 238 extend upwardly through the hollow columns 270 and, in some forms, protrude a least partially beyond the upper ends of the hollow columns 270.

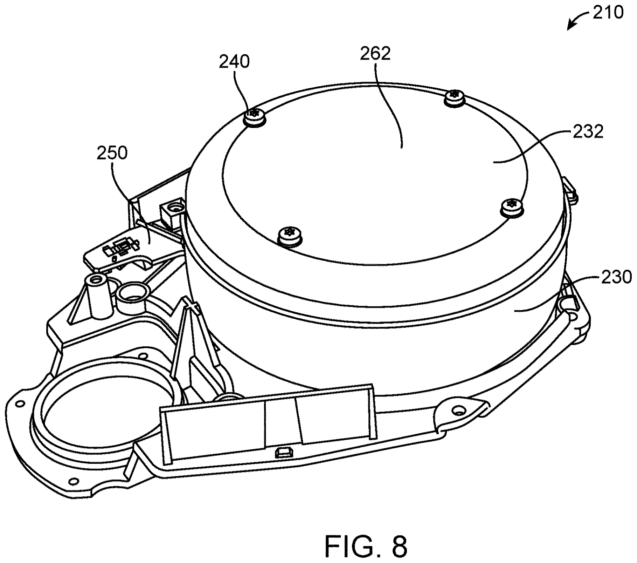

As best seen in FIG. 6, a plurality of standoffs 272 are secured to one or both of the guide pin posts 238 and the hollow columns 270. Further, guide pins 274 can be placed into the standoffs 272 for easier mounting of the inner shell lid 236 onto the inner shell bottom 234 and the outer shell lid 232 onto the outer shell bottom 230 through four equally spaced holes that may be about 1mm to about 3mm in diameter, such as 2.80mm in diameter. Once the inner shell lid 236 is placed onto the inner shell bottom 234 and the outer shell lid 232 is placed on the outer shell bottom 230, the guide pins 274 may be removed. With the guide pins 274 removed from the standoffs 272, the fasteners 240 (see FIG. 8) may be secured into the standoffs 272. The fasteners 240, along with the standoffs 272, secure the inner shell lid 236 to the inner shell bottom 234. The fasteners 240, along with the standoffs 272, also secure the outer shell lid 232 to the outer shell bottom 230.

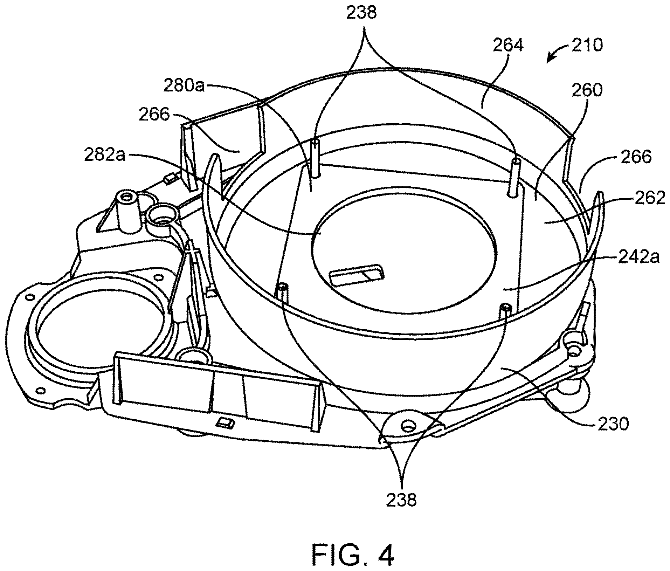

As depicted in FIGS. 4 and 7, the spacers 242a, 242b are provided in the form of a square plate 280a, 280b having a centrally disposed circular aperture 282a, 282b. The plates 280a, 280b each define a thickness dimension. In some forms, the thickness dimension of the plates 280a, 280b is between about 1mm and 3mm, such as 2mm. In some forms, there is an air gap provided between the inner shell layer and the outer shell layer by way of the one or more spacers 242a, 242b. For example, the spacer 242a can be placed inside the outer shell bottom 230 and mounted via the guide pin posts 238 to separate the outer shell bottom 230 and the inner shell bottom 234. The inner shell bottom 234 is placed on top of the spacer 242a and mounted via the guide pin posts 238. The placement of the spacer 242a and the thickness dimension of the spacer 242a creates an air gap between the outer shell bottom 230 and the inner shell bottom 234. Further, in an embodiment, the second spacer 242b can be added on top of the inner shell lid 236 between the inner shell lid 236 and the outer shell lid 232. The spacer 242b creates an additional air gap between the inner shell lid 236 and the outer shell lid 232. The air gaps can help reduce self-generated interference by the GNSS receiver module 250. In some forms, the air gaps may be provided at the same distance with respect to each other. In other forms, the air gaps may be provided at a different distance with respect to each other. In some specific instances, the air gap may be defined as a distance between the layers or a volume between the inner surfaces of the outer shell layer and the outer surfaces of the inner shell layer.

In an exemplary, non-limiting embodiment, the outer shell bottom 230 may have an internal diameter of about 90mm to about 110mm, such as 98mm. The guide pin posts 238 of the outer shell bottom 230 can form a pitch circle diameter of about 70mm to about 90mm, such as 78mm. The sidewall 264 of the outer shell bottom 230 can have a height of about 15mm to about 25mm, such as 23.4mm. Further, the flat surface 262 and the sidewall 264 of the outer shell bottom 230 can meet to form a curved edge with a radius of curvature of about 3° to about 8°, for example, 6.5°.

In an exemplary, non-limiting embodiment, the outer shell lid 232 may have an external diameter of about 90mm to about 110mm, such as 97.85mm. The flat surface 262 of the outer shell lid 232 may have a pitch circle diameter of about 70mm to about 90mm, such as 78mm, formed by a plurality of equally spaced holes. The sidewall 264 of the outer shell lid 232 can have a height of about 15mm to about 25mm, such as 21.8mm. Further, the flat surface 262 and the sidewall 264 of the outer shell lid 232 can meet to form a curved edge with a radius of curvature of about 3° to about 8°, for example, 6.5°. The outer shell bottom 230 and outer shell lid 232 may have a thickness of about 1mm to about 2mm, such as 1.5mm. When the outer shell bottom 230 and the outer shell lid 232 are assembled as the outer layer, an internal volume of the outer layer is about 300mL to 330mL.

In an exemplary, non-limiting embodiment, the inner shell bottom 234 may have an internal diameter of about 80mm to about 100mm, such as 91.10mm. The flat surface 262 of the inner shell bottom 234 may have a pitch circle diameter of about 70mm to about 90mm, such as 78mm, formed by the hollow columns 270. The sidewall 264 of the inner shell bottom 234 can have a height of about 10mm to about 15mm, such as 12.5mm. Further, the flat surface 262 and the sidewall 264 of the inner shell bottom 234 can meet to form a curved edge with a radius of curvature of about 1° to about 5°, for example, 3°.

Further, in an exemplary, non-limiting embodiment, the inner shell lid 236 may have an external diameter of about 80mm to about 100mm, such as 90.95mm. The flat surface 262 of the inner shell lid 236 may have a pitch circle diameter of about 70mm to about 90mm, such as 78mm, formed by a plurality of equally spaced holes. The sidewall 264 of the inner shell lid 236 can have a height of about 15mm to about 25mm, such as 19mm. Further, the flat surface 262 and the sidewall 264 of the inner shell lid 236 can meet to form a curved edge with a radius of curvature of about 1° to about 5°, for example, 2.5°. The inner shell bottom 234 and inner shell lid 236 may have a thickness of about 1mm to about 2mm, such as 1.5mm. When the inner shell bottom 234 and the inner shell lid 236 are assembled as the inner layer, an internal volume of the inner layer is about 175mL to 215mL. Further, the air gap between the inner layer and the outer layer can be between about 60mL and about 120mL.

The outer shell bottom 230, the outer shell lid 232, the inner shell bottom 234, and/or the inner shell lid 236 may be made out of various metals or metal alloys such as iron, copper, aluminum, zinc steel (Zintec), or a ferromagnetic material such as a nickel-iron alloy. One non-limiting example of a nickel-iron soft ferromagnetic alloy is MuMETAL^{®}, which can be used for shielding sensitive electronic equipment from static or low-frequency magnetic fields. To prevent interference with the electromagnetic field antennas 120, the directly radiated emissions from the GNSS receiver module 250 between about 45Hz to about 250kHz are preferably attenuated. This frequency range corresponds to the frequency of electricity delivered from the main power grid as well as the frequencies at which signal transmitters are used to induce signals in other underground assets that the locator device 100 can be used to identify. In order to attenuate frequencies within this spectrum, the multi-layer enclosure 210 can employ one or more materials in combination, such as iron and steel, iron and aluminum, iron and a nickel-iron alloy, steel and aluminum, steel and a nickel-iron alloy, Zintec and aluminum, or aluminum and a nickel-iron alloy. In some forms, using lower cost steel and aluminum materials for the multi-layer enclosure 210 may enhance high frequency performance at the upper end of the frequency range while also achieving the required interference attenuation.

In an embodiment, the outer shell bottom 230 and the outer shell lid 232 can be made from a first material, such as at least one of the metals or metal alloys listed above. The inner shell bottom 234 and inner shell lid 236 can be made from a second, different material with respect to the first material, such as at least one of the other metals or metal alloys listed above. Accordingly, the inner shell layer and the outer shell layer can comprise dissimilar materials. In some forms, the outer shell bottom 230 can be made from a different material than the outer shell lid 232. In some forms, the inner shell bottom 234 can be made from a different material than the inner shell lid 236. In some forms, the outer shell bottom 230 and the inner shell lid 236 can be made out of the first material, and the outer shell lid 232 and the inner shell bottom 234 can be made out of the second material. Accordingly, multiple materials can be provided in multiple layers to attenuate radiated emissions from the GNSS receiver module 250 positioned within the multi-layer enclosure 210. Although the multi-layer enclosure 210 can help attenuate directly radiated emissions from the GNSS receiver module 250, the GNSS receiver module 250 can also cause re-radiated or conducted emissions through the power module or cables connecting the power module to the GNSS receiver module 250. The re-radiated or conducted emissions also create interference with the electromagnetic field antennas 120. Accordingly, it can be useful to provide, in addition to the multi-layer enclosure 210, a smoothing circuit to attenuate re-radiated or conducted emissions.

For example, in some embodiments, the power module (not shown) may produce conducted and re-radiated emissions caused by the demand from the load, e.g., the system electronics and the GNSS receiver module 250. Accordingly, a smoothing circuit can be provided to reduce the interference generated by the demand on the power module from the interfering circuitry, such as the GNSS receiver module 250.

FIG. 9 illustrates a block diagram of a power module 400 and load 402 of a locator device, such as the underground utility locator device 100, without a smoothing circuit fitted. The power module 400 can include a battery 404, which can be connected to the load 402 by electrical cables, and a switch mode power supply (SMPS) 406 (see FIG. 10), which is also electrically connected to the load 402. The load 402 may consist of a voltage regulator and/or a voltage converter 408, which delivers power to various electronic modules, including a GNSS receiver module 410 (similar to the GNSS receiver module 250), a microprocessor 412, or other system electronics. Many of these electronic modules draw a fluctuating current and produce fast transient current loads that conduct back to the power source, which can produce interference in the desired locating frequency range if not contained.

The fluctuating current of FIG. 9, I_{LOAD}, circulates in a circuit from the power module 400 through the load 402 and back to the power module 400. If the fluctuating current is not contained, it creates a fluctuating re-radiated magnetic field from the electrical cables back to the battery 404 itself. Any frequency component within the passband of the receiving circuit, which is the circuit within the locator 100 that receives signals from the electromagnetic field antennas 120, will appear as self-generated noise, which prevents the receiving circuit from accurately detecting small signals. In addition, these conducted emissions can also directly couple onto the signal path to the receiving circuit, which contributes to the self-generated interference problem.

FIG. 10 illustrates a block diagram of the smoothing circuit 500 that has been fitted to the environment shown in FIG. 9. For example, FIG. 10 shows the power module 400, which includes the battery 404 and the SMPS 406, a shunt 414, the smoothing circuit 500, a multi-layer enclosure 416, and the load 402. The smoothing circuit 500 helps to confine the fluctuating current to the locality of the electronics and greatly reduces the fluctuation of the current at the power module 400. The load 402, as described with respect to FIG. 9, may include, but is not limited to, the voltage regulator and/or a voltage converter 408 and various electronic modules such as the GNSS receiver module 410 and the microprocessor 412, among others. The voltage regulator 408 may be a low dropout regulator to provide a constant voltage for the electronic modules such as the GNSS receiver module 410 and the microprocessor 412. Although I_{LOAD} may be a fluctuating current, the smoothing circuit 500 ensures that I_{SMOOTH} is a substantially constant current equal to the mean value of I_{LOAD}. By removing the current fluctuations, the part of the circuit between the power module 400 and the smoothing circuit 500 no longer contributes to the interfering magnetic field.

Further, the added multi-layer enclosure 416 contains and reduces the directly radiated self-interference emissions. The multi-layer enclosure 416 at least partially encloses the voltage regulator and/or a voltage converter 408, the GNSS receiver module 410, the microprocessor 412, and the smoothing circuit 500, all of which still carry the fluctuating current I_{LOAD}. In some forms, the SMPS 406 and the shunt 414 are also contained within the multi-layer enclosure 416. It is noted that the multi-layer enclosure 416 can be provided in the form of an enclosure according to the structure described above with respect to the multi-layer enclosure 210.

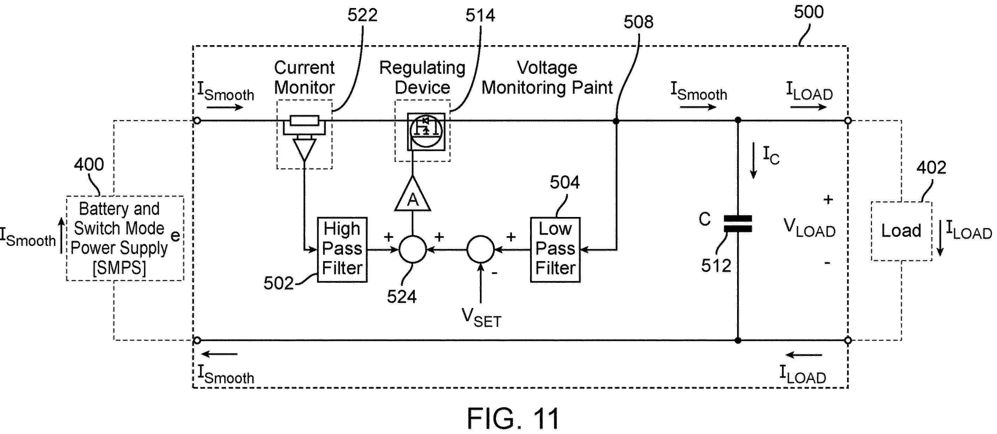

FIG. 11 illustrates a block diagram of an embodiment of the smoothing circuit 500 connected to the power module 400 and the load 402. FIG. 11 is an exemplary embodiment of the circuit design depicted in FIG. 10, but with the components of the smoothing circuit 500 illustrated in detail. The smoothing circuit 500 components may include, but are not limited to, a high-pass filter 502, a low-pass filter 504, a voltage monitor 508, a reservoir capacitor 512, a regulating device 514, a current monitor 522, and a sum and control module 524. In an embodiment, the regulating device 514 may be, but is not limited to, a P-type MOSFET.

The smoothing circuit 500 is in electrical communication with the power module 400, which includes the battery 404 and the SMPS 406 (see FIG. 10). The power delivered from the battery 404 and the SMPS 406 is a substantially fixed voltage. The current travels through the current monitor 522, the regulating device 514, and the voltage monitor 508 to the reservoir capacitor 512, which acts as a capacitive "tank". The current monitor 522 can include the shunt resistor 414. In an embodiment, the reservoir capacitor 512 discharges and delivers a variable voltage and variable current to the load 402.

The smoothing circuit 500 includes two control loops: a voltage control feedback loop and a current control feedforward loop. In an embodiment, the voltage control feedback loop maintains the output voltage, V_{LOAD}, around a voltage set point value, V_{SET}. The voltage control feedback loop incorporates the low-pass filter 504, which is effective at lower frequencies below the frequencies of interest for underground utility asset locating. V_{LOAD} is permitted to vary slightly above and below V_{SET}, but V_{LOAD} must remain above the minimum voltage required by the regulating device 514 and less than the voltage at the input of the smoothing circuit 500 in order to permit current flow into the reservoir capacitor 512 to be regulated.

The current control feedforward loop measures the input current, I_{SMOOTH}, and acts to keep I_{SMOOTH} substantially constant. In this embodiment, the current control feedforward loop incorporates the high-pass filter 502, which is effective at frequencies equal to or greater than the desired frequency range for underground utility asset locating. The error signal from the voltage feedback loop and the error signal from the current control feedforward loop are combined by the sum and control module 524. The voltage measurement feedback permits the current to fluctuate at frequencies below those of interest. This allows the incoming average I_{SMOOTH} current to be slowly adjusted. This slow adjustment will charge the reservoir capacitor 512 to the required average voltage, centered in the middle of its operational range. However, this adjustment is still fast enough to keep the voltage of the reservoir capacitor 512 between the minimum input voltage of the following linear regulator and the maximum output voltage of the smoothing circuit 500. The current control feedforward loop functions at frequencies above those of interest and inhibits fluctuations in the input current I_{SMOOTH} caused by the load variation, or indeed any remaining unfiltered voltage feedback adjustments, preventing the fluctuation of the load current I_{LOAD} from transferring to the input current I_{SMOOTH}.

The current flowing in the reservoir capacitor 512 has the value Ic = I_{SMOOTH} - I_{LOAD}, which is a fluctuating current with a mean value of zero. Consequently, there will be small variations in the voltage V_{LOAD}, which can be minimized by choosing a large capacitance value for the reservoir capacitor 512. In an exemplary embodiment, one practical design used a capacitance value of 10 mF. The subsequent voltage regulator 408 (see FIG. 10) provides the electronic modules, e.g., the GNSS receiver module 410 and the microprocessor 412 (see FIG. 10), with a closely controlled voltage rail.

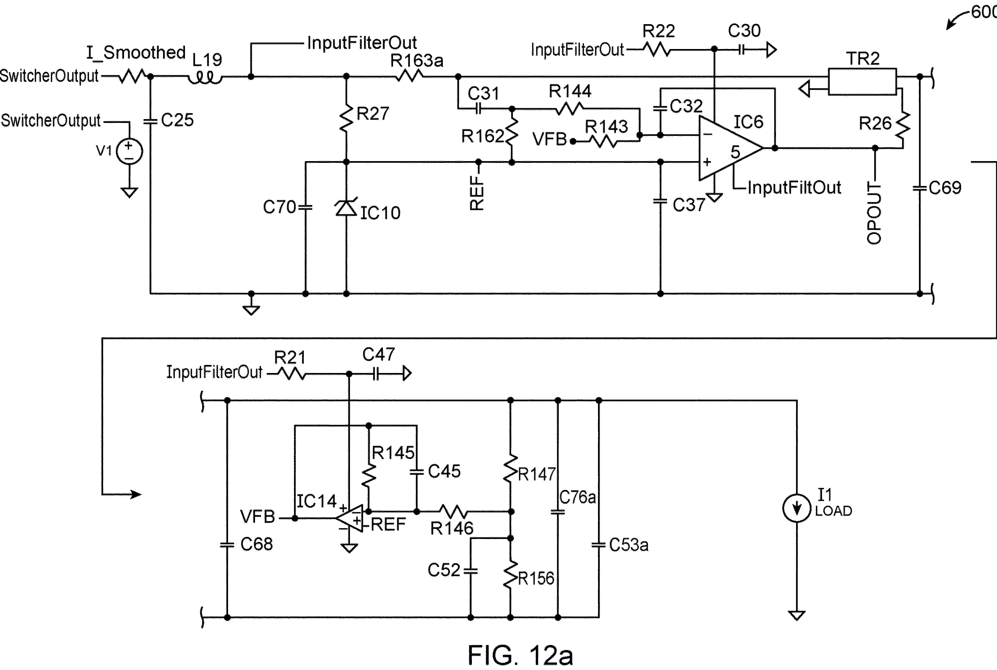

FIG. 12a shows an exemplary smoothing circuit 600 simulated in LTspice^{®}. In this embodiment, the capacitance values of the capacitors are capacitor C25 at 1µF, capacitor C30 at 0.1µF, capacitor C31 at 22µF, capacitor C32 at 4.7pF, capacitor C37 at 0.1µF, capacitor C45 at 10pF, capacitor C47 at 0.1µF, capacitor C52 at 300nF, capacitor C53a at 0.1µF, capacitor C68 at 1µF, capacitor C69 at 10µF, capacitor C70 at 1µF, and capacitor C76a at 10000µF. The inductance value of inductor L19 is 2.2µH. Additionally, in this embodiment, the resistance values of the resistors were simulated at resistor R21 at 3.3Ω, resistor R22 at 3.3Ω, resistor R26 at 75Ω, resistor R27 at 10kΩ, resistor R143 at 100kΩ, resistor R144 at 3.6kΩ, resistor R145 at 150kΩ, resistor R146 at 10kΩ, resistor R147 at 3.3kΩ, resistor R156 at 6.8kΩ, resistor R161 at 2.2kΩ, resistor R162 at 22k Ω, and resistor R163a at 110mΩ. The voltage value of V1 is set at 4V. The current value of I1 is set to 100mA, and the value of I2 is set to 1A. Further, an op-amp IC6 is provided in the form of an Analog Devices Inc. model LT1806 OP AMP, IC10 is provided in the form of an LT1634-2.5 or LM4128BMF-2.5, op-amp IC14 is provided in the form of an Analog Devices Inc. model AD8538 OP AMP, and TR2 is provided in the form of an onsemi^{®} model number FDN340P MOSFET.

In the embodiment shown in FIG. 12a, verification was performed to determine the capacitance values of the feedforward capacitor C31, the feedback capacitor C52, and the reservoir capacitor C76a. The feedforward capacitor C31 is configured to permit current control over the frequency range of interest, e.g., 45Hz to 250kHz, without fighting the voltage low frequency (VLF) and direct current (DC) control. The feedforward capacitor C31 has a large enough capacitance value to prevent excessive ripple of the line current.

The reservoir capacitor C76a has a capacitance value that is as small as possible while still achieving the desired attenuation of frequencies down to the lowest frequency of interest, e.g. 45Hz. In this exemplary embodiment, a higher value of the feedback capacitor C52 lowers the frequency response of the system for a given value of the reservoir capacitor C76a. However, if the capacitance value of feedback capacitor C52 is excessively high, it may degrade the transient step response in load current, I1. The capacity of the reservoir capacitor C76a, along with the fluctuation in load current I1 and permissible reservoir capacitor C76a voltage, determines the lowest frequency at which the smoothing circuit 600 can successfully reduce interference. The addition of the feedback capacitor C52 creates a second order filter and allows the quality factor (Q) to be increased while gaining extra low frequency performance. Excessive Q, which may be, but is not limited to, Q > 0.707, generates amplification at the filter frequency, which is undesirable unless this frequency is outside the desired frequency range. However, the maximally flat Q value of 0.707 is also not suitable due to the step response. In this application, the load current I1 exhibits step changes at a frequency below the detection bandwidth. However, step response ringing will be detrimental. Therefore, a lower Q value may be helpful.

The value of the feedback capacitor C52 is as large as possible without creating low frequency ringing for the desired frequency range, e.g., 45Hz to 250kHz. A non-limiting example of effective capacitance values is shown and described with respect to FIG. 12a e.g., the feedforward capacitor C31 value of 22µF, the reservoir capacitor C76a value of 10000µF, and the feedback capacitor C52 value of 330nF.

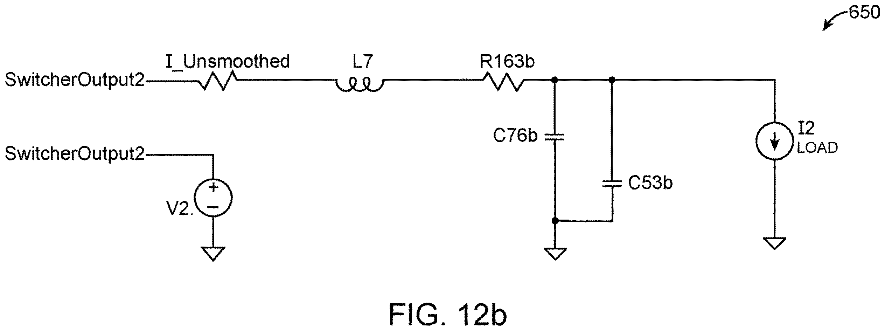

FIG. 12b illustrates a simulated circuit 650 that simulates the frequency response of a simple passive RC filter circuit without a smoothing circuit included. In the simulated circuit 650, the voltage V2 is set at 2.5V, current I Unsmoothed is 10mA, inductor L7 is 2.2µH, resistor R163b is 110mΩ, capacitor C76b is 10000µF, capacitor C53b is 0.1 µF, and current I2 is 500mA.

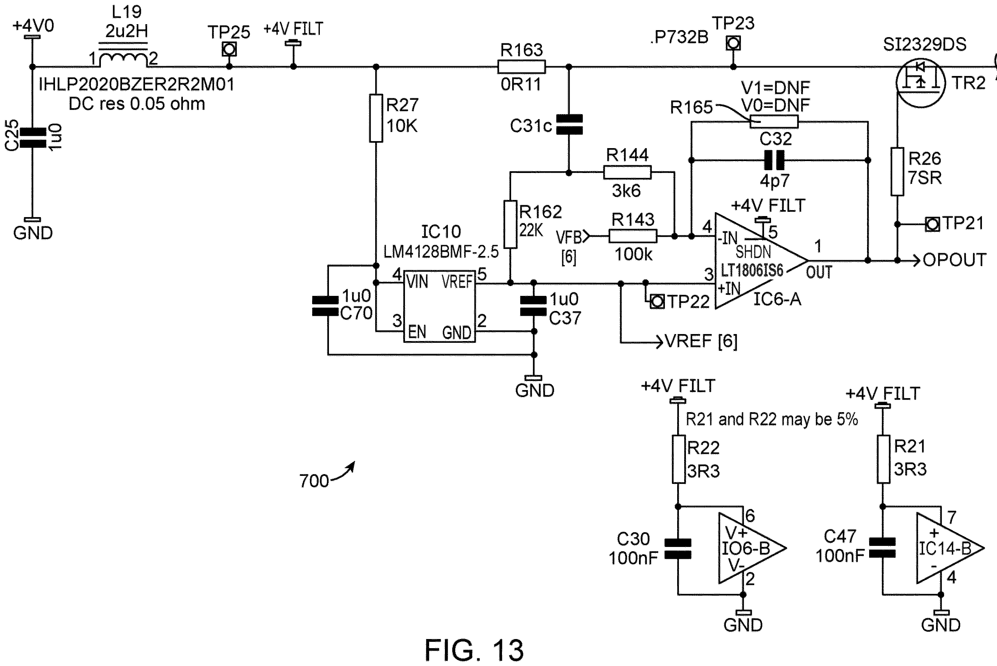

FIG. 13 illustrates a schematic diagram of a circuit 700 that emulates the features of the simulated smoothing circuit 600 described above with respect to FIG. 12a. The circuit 700 includes, but is not limited to, a feedforward capacitor C31c, a feedback capacitor C52c, a reservoir capacitor C76c, and other circuit components. The feedback capacitor C52c is used to alter the frequency response of the voltage feedback loop of the smoothing circuit of the circuit 700. The reservoir capacitor C76c provides the current variation demanded by the load, e.g., the GNSS receiver module 410, the microprocessor 412, and other system electronics. The voltage across the reservoir capacitor C76c is permitted to ripple provided that the voltage value does not exceed the maximum output voltage value of the smoothing circuit of the circuit 700, the voltage ripple does not prevent current control, and the voltage value does not drop below the minimum input voltage value of the voltage regulator supplying the load.

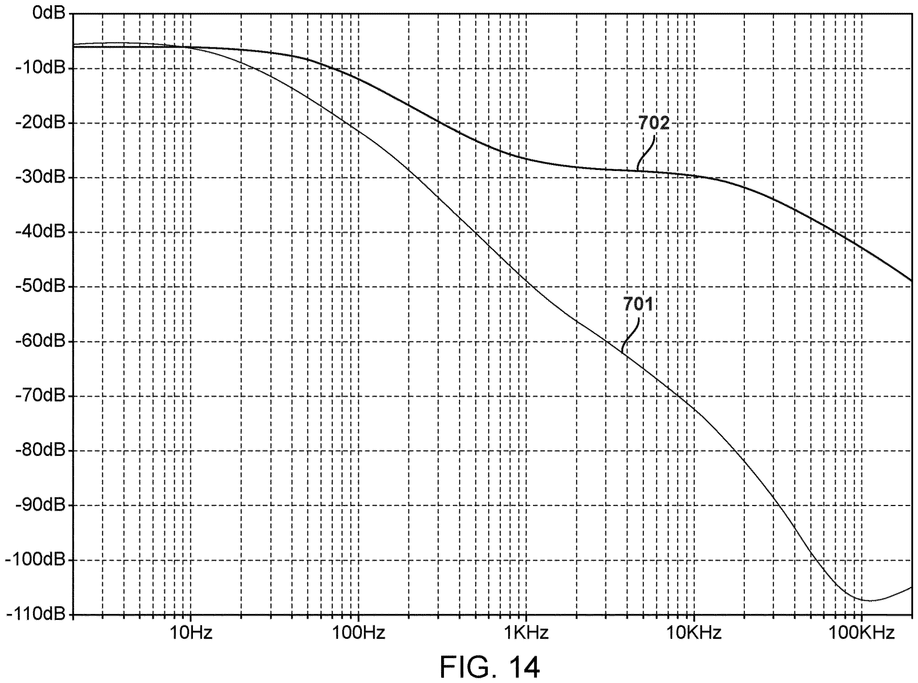

In FIG. 14, Line 701 (I Smoothed) represents the frequency response of the smoothing circuit 600 as shown and described with respect to FIG. 12a. The line 701 illustrates that the smoothing circuit 600 is effective at attenuating frequencies from at least about 40Hz to over 100kHz when the capacitance value of the feedforward capacitor C31 is 22µF. Additionally, when the feedforward capacitor C31 has a capacitance value of 22µF, the frequency response includes a sufficient transient step response when the frequency of the current is between about 40Hz and about 219Hz.

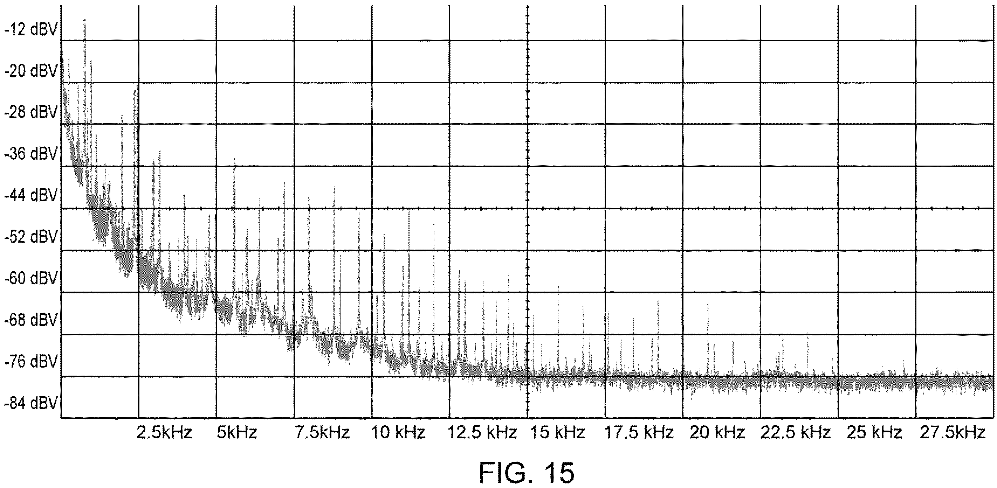

Further, Line 701 (I Smoothed) shows that the low-pass filter for voltage and the high-pass filter for current stabilization have been optimized with respect to the smoothing circuit 600 described above. The graph shows that fluctuations in I_{LOAD} are substantially attenuated over the full range of frequencies supported by the locator. In this exemplary embodiment, attenuation is maximum at around 83kHz. GNSS modules tend to cause significant interference above 5kHz (see FIG. 15). In particular, frequencies between about 30kHz to about 130kHz are generated at high levels from the interfering electronic modules used within the design, making this high degree of attenuation especially useful. Additionally, in FIG. 14, Line 702 (I Unsmoothed) represents the frequency response of the simulated circuit 650, which does not include a smoothing circuit, to demonstrate the before and after effectiveness of the smoothing circuit 600.

FIG. 15 is an example of the measurement of the frequency response without the smoothing circuit 600, which shows the unwanted interference from a GNSS receiver module, like the GNSS receiver module 250 and/or the GNSS receiver module 410. In this exemplary embodiment, which is not meant to be limiting, the GNSS receiver module is provided in the form of a U-Blox^{®} module, specifically model ZED-F9P. The conducted emissions were detected using the Fast Fourier Transform (FFT) feature of an oscilloscope connected to the battery terminals of the test device.

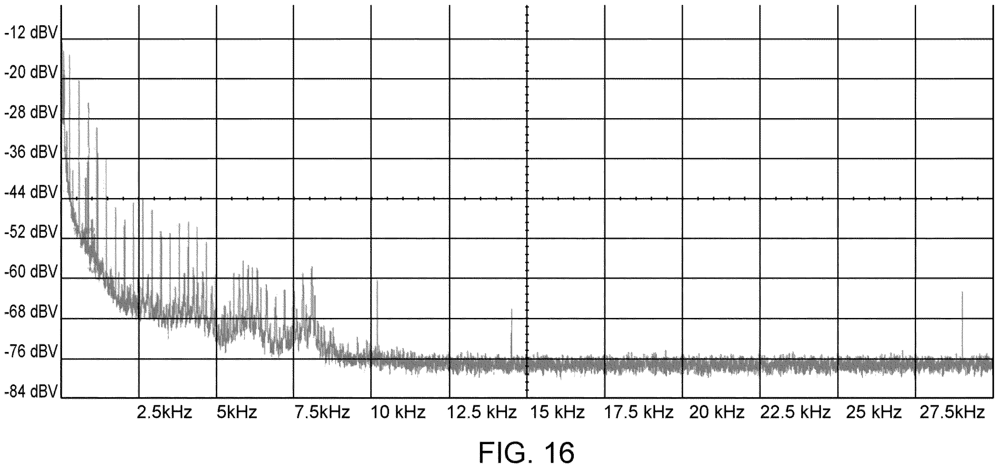

FIG. 16 is a measurement of the frequency response showing the significantly reduced GNSS receiver module interference when the smoothing circuit 600 is used. In this exemplary embodiment, which is not meant to be limiting, the GNSS receiver module is again provided in the form of a U-Blox^{®} module, specifically model ZED-F9P. FIG. 16 illustrates the measured conducted emissions of the GNSS receiver module and the system electronics with the reservoir capacitor C76a of the smoothing circuit 600 having a capacitance value of 10000µF, the feedforward capacitor C31 having a capacitance value of 22uF, and the feedback capacitor C52 having a capacitance value of 330nF. When FIG. 16 is compared with FIG. 15, it can be seen that a significant interference reduction across the spectrum has occurred when the smoothing circuit 600 is used.

### EXPERIMENTAL RESULTS

A full system evaluation was conducted on the electromagnetic locator device 100 with and without the multi-layer enclosure 110, 210 and the smoothing circuit 600 of FIG. 12, and the GNSS receiver module 250 provided in the form of a U-Blox^{®} RTK GNSS Receiver Module. The electromagnetic locator device 100 was tested in Active Mode, during which underground assets that are not radiating power signals are located, using a range of generated signal frequencies from 512Hz to 131,072Hz with a current of 10mA, attenuated by 44dB, and inserted into a two-meter-deep test line. Without the multi-layer enclosure 110, 210, and the smoothing circuit 600, the locator device 100 is unable to detect a clear frequency within the desired frequency range. When the multi-layer enclosure 110, 210, and the smoothing circuit 600 were added, any remaining interference from the GNSS receiver module 250 did not cause a measurable deterioration of the detection performance of the locator device 100. However, with a 120dB of gain on the electromagnetic locator device 100 and the GNSS receiver module 250 set to ON, the signals vary between 18% to 32%. Further, with a 120dB of gain on the electromagnetic locator device 100 and the GNSS receiver module 250 set to OFF, the signals vary between 24% to 32%, which indicates there is interference causing about 6% degradation when the GNSS receiver module 250 is set to OFF. When the maximum current is demanded by the GNSS receiver module 250, the display values are at their lowest, as indicated by the electromagnetic locator device 100. The current consumption of the GNSS receiver module 250 follows a cyclic pattern where the maximum current appears to generate maximum electromagnetic interference. The highest display indication is the same whether the GNSS receiver module 250 is ON or OFF. This exemplary embodiment of the electromagnetic locator device 100 was effective at current and depth measurements of 9.8kHz, 33kHz, and 200kHz. In other embodiments, it may be effective at other current and depth measurements.

It will be appreciated by those skilled in the art that while the invention has been described above in connection with particular embodiments and examples, the invention is not necessarily so limited and that numerous other embodiments, examples, uses, modifications, and departures from the embodiments, examples, and uses are intended to be encompassed by the claims attached hereto. Various features and advantages of the invention are set forth in the following claims.

## Claims

1. An underground utility locator comprising:
a wand having a top end and a bottom end and including at least one antenna configured to output a field strength signal in response to an electromagnetic field;
a GNSS module;
a power module coupled to the wand, the power module including a smoothing circuit for providing a substantially constant current; and
a multi-layer enclosure at least partially surrounding the GNSS module, the multi-layer enclosure comprising:
an outer metal shell layer and an inner metal shell layer, wherein the outer metal shell layer and the inner metal shell layer are at least partially separated by an air gap.

2. The underground utility locator of claim 1, wherein the outer metal shell layer comprises a first metal and the inner metal shell layer comprises a second metal.

3. The underground utility locator of claim 1 or 2, wherein the multi-layer enclosure has at least one spacer above the inner metal shell layer and at least one spacer below the inner metal shell layer.

4. The underground utility locator of any one of claims 1 to 3, wherein the smoothing circuit includes:
an incoming rippling current with a rippling effect;
a feedforward capacitor that delivers the rippling effect of the incoming rippling current;
a reservoir capacitor with a rippling voltage, wherein the reservoir capacitor discharges to reduce the rippling effect of the incoming rippling current; and
a feedback capacitor, wherein the feedback capacitor controls a quality factor of a filter of the smoothing circuit.

5. The underground utility locator of claim 4, further comprising an outgoing current from the power module to the GNSS module, wherein the reduced rippling effect includes the outgoing current being substantially constant.

6. The underground utility locator of claim 4, wherein the rippling voltage on the reservoir capacitor is permitted to ripple when the rippling voltage is within a permitted range.

7. The underground utility locator of claim 4, wherein the feedback capacitor lowers a frequency response of the smoothing circuit.

8. The underground utility locator of claim 4, wherein the feedforward capacitor is removable.

9. The underground utility locator of claim 4, wherein the reservoir capacitor controls a frequency attenuation and the feedback capacitor controls a step performance.

10. The underground utility locator of any one of claims 1 to 9, wherein the GNSS module demands a variable current.

11. The underground utility locator of any one of claims 1 to 10, wherein the smoothing circuit is configured to filter out frequencies between 45Hz and 1kHz.

12. The underground utility locator of any one of claims 1 to 11, wherein the smoothing circuit is configured to filter out frequencies between 1kHz to 50kHz.

13. The underground utility locator of any one of claims 1 to 12, wherein the smoothing circuit is configured to filter out frequencies between 50kHz and 250kHz.

14. The underground utility locator of any one of claims 1 to 13, further comprising an electronics housing coupled to the top end of the wand, and the GNSS module is positioned within the electronics housing.

15. The underground utility locator of any one of claims 1 to 14, further comprising a power module housing coupled to the wand, and the power module is positioned within the power module housing.
